Europäisches Patentamt

(19) European Patent Office

Office européen des brevets

(11) Publication number: **0 019 337**
**B1**

# EUROPEAN PATENT SPECIFICATION

(45) Date of publication of patent specification: **07.09.83**

(51) Int. Cl.³: **H 01 L 41/18, H 01 L 41/22**

(21) Application number: **80200439.0**

(22) Date of filing: **12.05.80**

(54) Piezoelectric body for an electromechanical transducer.

(30) Priority: **21.05.79 NL 7903964**

(43) Date of publication of application:
**26.11.80 Bulletin 80/24**

(45) Publication of the grant of the patent:
**07.09.83 Bulletin 83/36**

(84) Designated Contracting States:
**BE CH DE FR GB LI NL SE**

(56) References cited:
**DE - A - 2 932 870**
**FR - A - 2 332 962**
**US - A - 3 663 440**

**JAPAN ELECTRONIC ENGINEERING, nr. 146,**
**February 1979 TOKYO (JP)**
**K. OKAZAKI: "Piezoelectric ceramic**
**materials attain perfection", pages 44—47**

(73) Proprietor: **N.V. Philips' Gloeilampenfabrieken**
**Groenewoudseweg 1**
**NL-5621 BA Eindhoven (NL)**

(72) Inventor: **Perduijn, David Jacob**
**c/o INT. OCTROOIBUREAU B.V. Prof. Holstlaan 6**
**NL-5656 AA Eindhoven (NL)**
Inventor: **Verberkt, Jacobus**
**c/o INT. OCTROOIBUREAU B.V. Prof. Holstlaan 6**
**NL-5656 AA Eindhoven (NL)**

(74) Representative: **Jelmorini, Pius Antonius et al,**
**INTERNATIONAAL OCTROOIBUREAU B.V. Prof.**
**Holstlaan 6**
**NL-5656 AA Eindhoven (NL)**

# 0 019 337

Piezoelectric body for an electromechanical transducer.

The invention relates to a piezoelectric body for an electro-mechanical transducer comprising ceramic piezoelectric material.

This type of ceramic material is known from FR—A—2,332,962 with a composition within the general formula.

$$\sum_{n=1}^{n} a_{n-1} \ (Pb_{1-\alpha_{n-1}} L_{\alpha_{n-1}}) (M_{n-1}N_{n-1})O_3. \ yPbTiO_3.zPbZrO_3,$$

in which $a_{n-1}$, y and z are the respective mole fractions of the constituents, the constituent

$$(Pb_{1-\alpha_{n-1}} L_{\alpha_{n-1}}) (M_{n-1}N_{n-1})O_3$$

is a compound of a structure chosen from perowskite, pyrochlore, bismuth oxide layer type of tungsten bronze type, L being chosen from Ca, Sr, Ba, Li, Na, K, Ag, La, Bi, Cd and Nd and $M_{n-1}$, $N_{n-1}$ being each a substance chosen in the group comprising $Mn_{1/3}$, $Mn_{1/2}$, $Zn_{1/3}$, $Co_{1/3}$, $Ni_{1/3}$, $Fe_{1/3}$, $Fe_{1/2}$, $Sc_{1/2}$, $In_1$, $Cd_{1/2}$, $Mg_{1/3}$, $Mg_{1/2}$, $Sn_{1/3}$, $Sn_{1/2}$, $Ta_{1/2}$, $Nb_{1/2}$, $Nb_{2/3}$, $Sb_{1/2}$, $Sb_{2/3}$, $W_{1/3}$, $Cr_{1/2}$, $Sn_{1-\beta}$, $Hf_{1-\beta}$, $Nb_{1-\beta}$, and $Ta_{1-\beta}$, being between 0 and 1, n is an integer between 1 and 4, preferably between 1 and 3, if

$$\sum_{n=1}^{n} a_{n-1}$$

is represented by x, x+y+z being 1,00, $0 \leqslant x \leqslant 0.40$; $0.05 \leqslant y \leqslant 0.45$, $0.40 \leqslant z \leqslant 0.95$ and $0.00 \leqslant \alpha_{n-1} \leqslant 1.00$. In this disclosure the step of polarization has been indicated as having to take place at a temperature between 20 and 200°C. Polarization is necessary in order to make the ceramic body suitable for use as a piezoelectric transducer, that is to say the elementary electric dipoles must be irreversibly oriented in an electric field.

Data from the literature (e.g. US—PS 3,268,453 giving the composition $PbTiO_3$ — $PbZrO_3$ — $Pb(Mg_{1/3}Nb_{2/3})O_3$ within the range of compositions of the above FR—A and the Applicant's own experience teaches that polarization should take place at a temperature between 100 and 200°C for a period of time of about 1 hour in an electrically non-conductive oil at a field strength of 1.5—4 MV/m (KV/mm).

The piezoelectric body for an electromechanical transducer on the basis of the ternary system lead titanate — lead zirconate and a lead compound of the type wherein part of the total Ti and Zr has been replaced by 1/3 mole of a bivalent metal and by 2/3 mole of a pentavalent metal, is characterized according to the invention in that it consists of $Pb_{1-a}M_a(Mg_{(1-b)/3}Mn_{b/3}Sb_{2/3})_x Ti_yZrO_3$, wherein M is one or more of the alkaline earth metals Ca, Sr and Ba,

$0 \leqslant a \leqslant 0.15$,
$0 \leqslant b \leqslant 0.20$,
$0.01 \leqslant x \leqslant 0.25$,
$0.40 \leqslant y \leqslant 0.55$,
$0.20 \leqslant z \leqslant 0.59$ and $(x + y + z) = 1$.

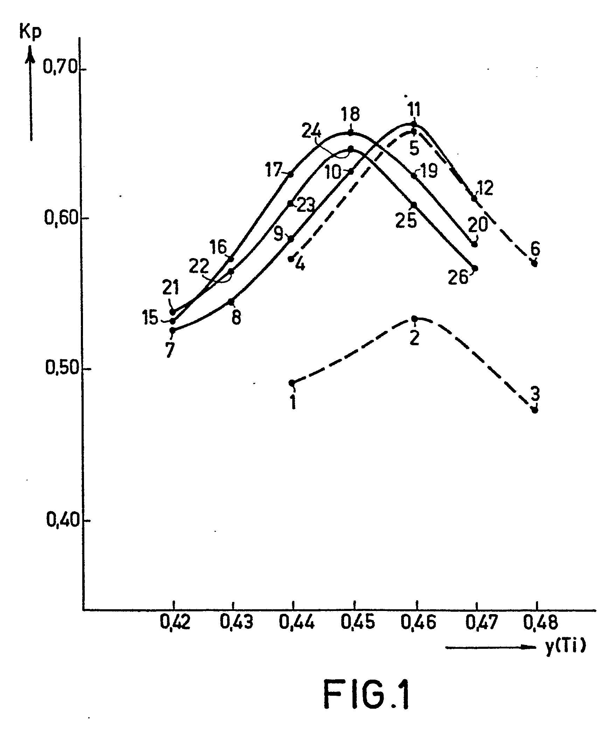

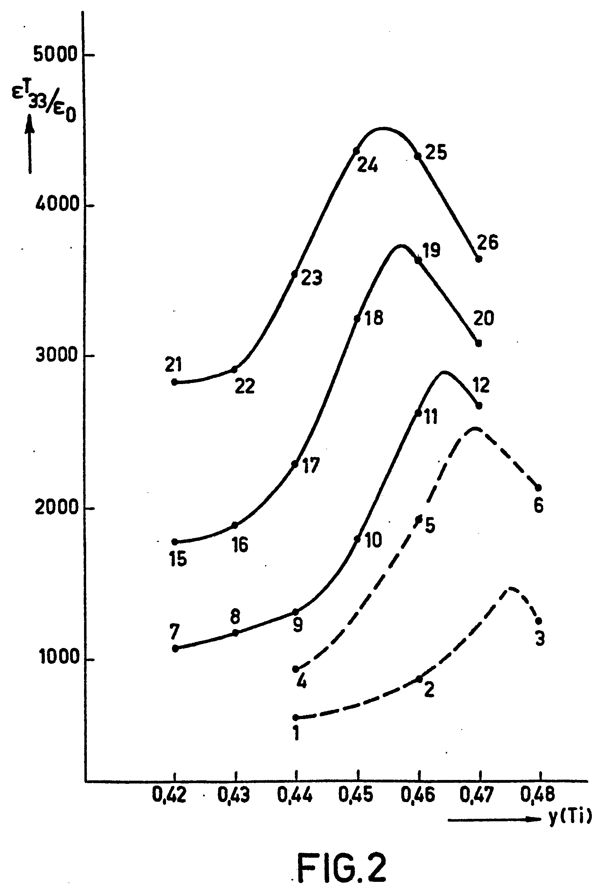

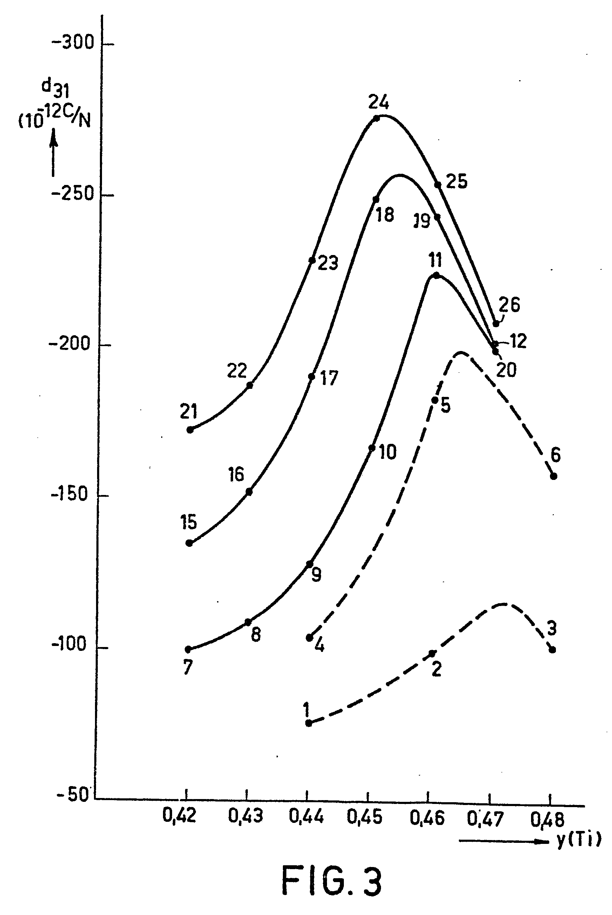

According to the invention there is provided a piezoelectric material having a composition within a range wherein a formed body consisting of this material can as a rule be polarised in a very short period of time (between 1 sec. and 5 min.) at room temperature so as to produce polarized bodies having good piezoelectric properties (see the drawings, wherein $K_p$ (Fig. 1), $\varepsilon_{33}^T/\varepsilon_0$ (Fig. 2) and $d_{31}$ (Fig. 3) are shown as a function of the composition. In addition, the material according to the invention has the advantage that the piezoelectric properties have a satisfactory stability as a function of the temperature and the time, in spite of the short polarisation time. The piezoelectric response changes only slightly up to 100°C and has a good stability with time.

The feature that polarisation can be effected at room temperature has the important advantage that the piezoelectric body can be built into an assembly and that this assembly is subject to the polarisation treatment.

This assembly is made, for example by securing the piezoelectric body to a membrane with an adhesive which is cured at an elevated temperature (> 150°C), or by soldering the piezoelectric body to a substrate. The fact that polarisation is not effected until after the assembly is at room temperature prevents the piezoelectric properties of the body from degenerating by reason of the polarized body being heated to the high temperature at which the body is attached.

According to an elaboration of the invention, a further improvement of the properties is

2

accomplished by replacing up to a total of 15 mol.% of Pb equimolarly by one or more of the alkaline earth metals Ca, Sr and Ba.

A reduction in the loss factor (tan $\delta$) is accomplished by replacing up to 20 mol.% of the Mg by Mn. This is advantageous for some applications.

A further range of compositions is found between the boundaries:

$x = 0.125 - 0.15$
$y = 0.44 - 0.46$ and
$z - 0.38 - 0.44$,

in a composition of the general formula

$Pb_{1-a}Sr_a \{(Mg_{1-b}Mn_b)_{1/3}Sb_{2/3}\}_x Ti_y Zr_z O_3$

in which a (= the molar fraction of Sr) is 0.05 and b is the molar fraction of Mn. These compositions can be polarised at room temperature within 1 sec. They are suitable for low-power uses, having a high sensitivity and a high piezoelectric response, and are therefore particularly suitable for use in buzzers, smoke detectors and high-frequency loudspeakers.

The invention will now be further illustrated with reference to a number of embodiments.

The starting materials, namely lead oxide (PbO), magnesium oxide (MgO), antimony pentoxide ($Sb_2O_5$), titanium dioxide ($TiO_2$) and zirconium dioxide ($ZrO_2$), and, if necessary, SrO, BaO, CaO and/or $MnO_2$, all these materials being of a chemically pure quality, are mixed with distilled water in a rubber-lined ball mill.

After wet-milling, the mixture is dried. Thereafter the mixture is subjected to a first reaction by heating the mixture for 2 hours at a temperature of approximately 850°C in an oxygen atmosphere.

The material is thereafter allowed to cool, whereafter it is milled again. The powder thus obtained is then compressed to form cylinders having a diameter of 15 mm and a height of 20 mm, using a pressure of 70 MPa and the cylinders are sintered for 45 minutes at 1150—1300°C depending on the composition in an oxygen atmosphere, in an enclosed space of refractory material, to prevent evaporation of lead. After cooling the cylinders are reduced to 12 mm by grinding the ground cylinders and are sawn into discs of 1 mm thick.

After having been provided with electrodes, the discs are polarised in air or in silicone oil for 1 sec. to 5 minutes at a temperature between 20 and 200°C depending on the composition, in a field of 1—3 MV/m.

The following Table I shows a number of compositions within the range according to the invention with a number of physical properties, namely the density $\rho_s$, the dielectric constant $\varepsilon_{33}^T / \varepsilon_o$, the dielectric loss factor tan $\delta$, the planar coupling coefficient $k_p$, the frequency constant $N_p$ and the change constant $d_{31}$.

Table II illustrates the time stability and the temperature stability, measured 24 hours after composition 18 of Table I had been subjected to a temperature treatment at 100°C for 1 hour.

The Figures illustrate the above-mentioned quantities as a function of the Ti-content, the numbers of the points in the Figures corresponding to the respective numbered compositions listed in Table I.

# TABLE I

General formula $Pb_{1-a}Sr_a\{(Mg_{1-b}Mn_b)_{1/3}Sb_{2/3}\}_xTi_yZr_zO_3$

| Ex. no. | Molar ratio of basic composition | | | substituents | | | | 24 hours after polarizing | | | |
| | $(PbMg_{1/3}Sb_{2/3}O_3)$ x | $(PbTiO_3)$ y | $(PbZrO_3)$ z | (Sr) a | (Mn) b | $\rho_s$ (g/cm³) | $\varepsilon^T_{33}/\varepsilon_0$ at 1 kHz | tan δ at 1 kHz ($\times 10^{-4}$) | $k_p$ | $N_p$ (Hz·m) | $d_{31}$ ($10^{-12}$C/N) |
|---|---|---|---|---|---|---|---|---|---|---|---|
| 1 | 0.05 | 0.44 | 0.51 | 0 | 0 | 7.77 | 625 | 165 | 0.491 | 2210 | −76 |
| 2 | 0.05 | 0.46 | 0.49 | 0 | 0 | 7.77 | 880 | 138 | 0.533 | 2180 | −99 |
| 3 | 0.05 | 0.48 | 0.47 | 0 | 0 | 7.77 | 1250 | 104 | 0.473 | 2210 | −103 |
| 4 | 0.125 | 0.44 | 0.435 | 0 | 0 | 8.06 | 950 | 166 | 0.573 | 2260 | −104 |
| 5 | 0.125 | 0.46 | 0.415 | 0 | 0 | 8.06 | 1950 | 141 | 0.658 | 2060 | −189 |
| 6 | 0.125 | 0.48 | 0.395 | 0 | 0 | 8.06 | 2150 | 109 | 0.570 | 2230 | −158 |
| 7 | 0.125 | 0.42 | 0.455 | 0.02 | 0 | 8.00 | 1085 | 201 | 0.526 | 2335 | −100 |
| 8 | 0.125 | 0.43 | 0.445 | 0.02 | 0 | 8.00 | 1185 | 196 | 0.544 | 2295 | −109 |
| 9 | 0.125 | 0.44 | 0.435 | 0.02 | 0 | 8.00 | 1310 | 180 | 0.589 | 2230 | −128 |
| 10 | 0.125 | 0.45 | 0.425 | 0.02 | 0 | 8.00 | 1795 | 171 | 0.628 | 2125 | −168 |
| 11 | 0.125 | 0.46 | 0.415 | 0.02 | 0 | 8.01 | 2620 | 165 | 0.663 | 2026 | −225 |
| 12 | 0.125 | 0.47 | 0.405 | 0.02 | 0 | 8.00 | 2675 | 141 | 0.613 | 2115 | −201 |

TABLE I (continued)

General formula $Pb_{1-a}Sr_a\{(Mg_{1-b}Mn_b)_{1/3}Sb_{2/3}\}_xTi_yZr_zO_3$

| | Molar ratio of basic composition | | | substituents | | 24 hours after polarizing | | | | | |
|---|---|---|---|---|---|---|---|---|---|---|---|
| Ex. no. | $(PbMg_{1/3}Sb_{2/3}O_3)$ x | $(PbTiO_3)$ y | $(PbZrO_3)$ z | $(Sr)$ a | $(Mn)$ b | $\rho_s$ (g/cm³) | $\varepsilon_{33}^T/\varepsilon_0$ at 1 kHz | tan $\delta$ at 1 kHz ($\times 10^{-4}$) | $k_p$ | $N_p$ (Hz·m) | $d_{31}$ ($10^{-12}$ C/N) |
| 13 | 0.125 | 0.40 | 0.475 | 0.05 | 0 | 7.92 | 1535 | 219 | 0.514 | 2340 | −116 |
| 14 | 0.125 | 0.41 | 0.465 | 0.05 | 0 | 7.91 | 1590 | 211 | 0.525 | 2305 | −123 |
| 15 | 0.125 | 0.42 | 0.455 | 0.05 | 0 | 7.90 | 1780 | 230 | 0.533 | 2255 | −135 |
| 16 | 0.125 | 0.43 | 0.445 | 0.05 | 0 | 7.91 | 1865 | 200 | 0.573 | 2210 | −151 |
| 17 | 0.125 | 0.44 | 0.435 | 0.05 | 0 | 7.91 | 2285 | 200 | 0.629 | 2115 | −192 |
| 18 | 0.125 | 0.45 | 0.425 | 0.05 | 0 | 7.91 | 3245 | 210 | 0.657 | 2030 | −249 |
| 19 | 0.125 | 0.46 | 0.415 | 0.05 | 0 | 7.90 | 3625 | 180 | 0.629 | 2085 | −245 |
| 20 | 0.125 | 0.47 | 0.405 | 0.05 | 0 | 7.89 | 3080 | 147 | 0.583 | 2195 | −199 |
| 21 | 0.15 | 0.42 | 0.43 | 0.05 | 0 | 7.95 | 2835 | 257 | 0.537 | 2220 | −173 |
| 22 | 0.15 | 0.43 | 0.42 | 0.05 | 0 | 7.96 | 2910 | 258 | 0.564 | 2175 | −188 |
| 23 | 0.15 | 0.44 | 0.41 | 0.05 | 0 | 7.95 | 3555 | 290 | 0.610 | 2115 | −231 |
| 24 | 0.15 | 0.45 | 0.40 | 0.05 | 0 | 7.96 | 4345 | 293 | 0.646 | 2060 | −278 |
| 25 | 0.15 | 0.46 | 0.39 | 0.05 | 0 | 7.96 | 4305 | 233 | 0.609 | 2110 | −255 |

TABLE I (continued)

General formula $Pb_{1-a}Sr_a\{(Mg_{1-b}Mn_b)_{1/3}Sb_{2/3}\}_xTi_yZr_zO_3$

| Molar ratio of basic composition | | | | substituents | | 24 hours after polarizing | | | | | |
|---|---|---|---|---|---|---|---|---|---|---|---|
| Ex. no. | $(PbMg_{1/3}Sb_{2/3}O_3)$ $x$ | $(PbTiO_3)$ $y$ | $(PbZrO_3)$ $z$ | $(Sr)$ $a$ | $(Mn)$ $b$ | $\rho_s$ $(g/cm^3)$ | $\varepsilon_{33}^T/\varepsilon_0$ at 1 kHz | tan $\delta$ at 1 kHz $(\times10^{-4})$ | $k_p$ | $N_p$ $(Hz \cdot m)$ | $d_{31}$ $(10^{-12}C/N)$ |
| 26 | 0.15 | 0.47 | 0.38 | 0.05 | 0 | 7.96 | 3650 | 180 | 0.567 | 2200 | −209 |
| 27 | 0.175 | 0.42 | 0.405 | 0.05 | 0 | 7.98 | 5730 | 545 | 0.358 | 2385 | −153 |
| 28 | 0.175 | 0.43 | 0.395 | 0.05 | 0 | 7.98 | 5715 | 530 | 0.428 | 2325 | −187 |
| 29 | 0.175 | 0.44 | 0.385 | 0.05 | 0 | 7.96 | 5325 | 355 | 0.555 | 2200 | −248 |
| 30 | 0.175 | 0.46 | 0.365 | 0.05 | 0 | 7.98 | 5030 | 420 | 0.427 | 2294 | −177 |
| 31 | 0.20 | 0.42 | 0.38 | 0.05 | 0 | 7.96 | 5855 | 570 | 0.235 | 2495 | −97 |
| 32 | 0.20 | 0.43 | 0.37 | 0.05 | 0 | 7.96 | 5910 | 570 | 0.280 | 2450 | −118 |
| 33 | 0.20 | 0.44 | 0.36 | 0.05 | 0 | 7.97 | 5950 | 580 | 0.363 | 2380 | −158 |
| 34 | 0.20 | 0.45 | 0.35 | 0.05 | 0 | 7.98 | 5920 | 460 | 0.450 | 2300 | −202 |
| 35 | 0.20 | 0.46 | 0.34 | 0.05 | 0 | 7.98 | 5500 | 330 | 0.494 | 2265 | −217 |

TABLE I (continued)

General formula $Pb_{1-a}Sr_a\{(Mg_{1-b}Mn_b)_{1/3}Sb_{2/3}\}_xTi_yZr_zO_3$

| | Molar ratio of basic composition | | | | substituents | | 24 hours after polarizing | | | | | |
|---|---|---|---|---|---|---|---|---|---|---|---|---|
| Ex. no. | $(PbMg_{1/3}Sb_{2/3}O_3)$ x | $(PbTiO_3)$ y | $(PbZrO_3)$ z | (Sr) a | (Mn) b | $\rho_s$ (g/cm³) | $\varepsilon_{33}^T/\varepsilon_0$ at 1 kHz | tan $\delta$ at 1 kHz ($\times 10^{-4}$) | $k_p$ | $N_p$ (Hz . m) | $d_{31}$ ($10^{-12}$C/N) |
| 36 | 0.20 | 0.47 | 0.33 | 0.05 | 0 | 7.98 | 4655 | 230 | 0.499 | 2280 | −201 |
| 37 | 0.125 | 0.45 | 0.425 | 0.05 | 0 | 7.93 | 3230 | 197 | 0.668 | 1995 | −256 |
| 38 | 0.125 | 0.45 | 0.425 | 0.05 | 0.05 | 7.93 | 3130 | 130 | 0.659 | 2020 | −246 |
| 39 | 0.125 | 0.45 | 0.425 | 0.05 | 0.10 | 7.95 | 2850 | 68 | 0.656 | 2060 | −229 |
| 40 | 0.125 | 0.45 | 0.425 | 0.05 | 0.20 | 7.93 | 2210 | 29 | 0.638 | 2150 | −188 |

TABLE II

| | time stability (% per decade) | | temperature stability (% per decade) | |
|---|---|---|---|---|
| | polarizing temperature | | polarizing temperature | |
| | 25°C | 150°C | 25°C | 150°C |
| $\varepsilon_{33}^T/\varepsilon_0$ | −1.8 | −0.6 | +16 | +14 |
| $K_p$ | −0.7 | −0.4 | −2.3 | −3.4 |
| $N_p$ | +0.15 | +0.1 | +0.15 | 0 |
| $d_{31}$ | −2.5 | −0.8 | +4.7 | +3.7 |

## Claims

1. A piezoelectric body for an electromechanical transducer on the basis of the ternary system lead titanate-lead zirconate — $Pb(M^{II}_{1/3} \ M^{V}_{2/3})O_3$, characterised in that it consists of $Pb_{1-a}M_a(Mg_{(1-b)/3}Mn_{b/3}Sb_{2/3})_xTi_yZr_zO_3$ wherein M is one or more of the alkaline earth metals Ca, Sr and Ba,

$$0 \leqslant a \leqslant 0.15,$$
$$0 \leqslant b \leqslant 0.20,$$
$$0.01 \leqslant x \leqslant 0.25,$$
$$0.40 \leqslant y \leqslant 0.55,$$
$$0.20 \leqslant z \leqslant 0.59 \text{ and}$$
$$(x + y + z) = 1.$$

2. A body as claimed in Claim 1, characterized in that $0.125 \leqslant x \leqslant 0.15$, $0.44 \leqslant y \leqslant 0.46$ and $0.38 \leqslant z \leqslant 0.44$, M is Sr and the molar fraction of Sr is 0.05.

3. An electromechanical transducer comprising a piezoelectric body as claimed in Claims 1 or 2.

4. A method of producing a piezoelectric body as claimed in Claims 1 or 2, characterized in that the ceramic body obtained after sintering the appropriate starting materials is polarised at a temperature between 20 and 200°C in air or in elastically non-conducting oil in a field of 1—3 MV/m for a period of time between 1 sec. and 5 minutes.

5. A method of producing an assembly wherein a piezoelectric body as claimed in claims 1 or 2 is secured at an elevated temperature to a device, characterized in that polarisation is effected at room temperature after completing the securing operation.

## Revendications

1. Corps piézo-électrique pour un transducteur électromécanique à base du système ternaire de titanate de plomb — zirconate de plomb — $Pb(M^{II}_{1/3}M^{V}_{2/3})O_3$, caractérisé en ce qu'il est constitué par $Pb_{1-a}M_a(Mg_{(1-b)/3}Mn_{b/3}Sb_{2/3})_xTi_yZr_zO_3$, formule dans laquelle M est au moins l'un des matériaux alcalino-terreux Ca, Sr et Ba,

$$0 \leqslant a \leqslant 0,15,$$
$$0 \leqslant b \leqslant 0,20,$$
$$0,01 \leqslant x \leqslant 0,25,$$
$$0,40 \leqslant y \leqslant 0,55,$$
$$0,20 \leqslant z \leqslant 0,59 \text{ et}$$
$$(x + y + z) = 1.$$

2. Corps selon la revendication 1, caractérisé en ce que $0,125 \leqslant x \leqslant 0,15$, $0,44 \leqslant y \leqslant 0,46$ et $0,38 \leqslant z \leqslant 0,44$, M est Sr et la fraction molaire du Sr est de 0,05.

3. Transducteur électromécanique comportant un corps piézo-électrique selon la revendication 1 ou 2.

4. Procédé pour la réalisation d'un corps piézo-électrique selon la revendication 1 ou 2, caractérisé en ce que le corps céramique obtenu après frittage du matériau de départ approprié est polarisé à une température comprise entre 20 et 200°C dans de l'air ou dans une huile non électroconductrice dans un champ de 1 à 3 MV/m pendant une période comprise entre 1 sec. et 5 minutes.

5. Procédé pour la réalisation d'un ensemble dans lequel le corps piézo-électrique comme revendiqué dans les revendications 1 ou 2 est fixé à une température élevée à un dispositif, caractérisé en ce que la polarisation s'effectue à la température ambiante normale après la fixation.

## Patentansprüche

1. Piezoelektrischer Körper für einen elektromechanischen Wandler auf Basis des ternären Systems Bleititanat-Bleizirkonat-$Pb(M^{II}_{1/3}M^{V}_{2/3})O_3$ dadurch gekennzeichnet, dass er aus $Pb_{1-a}M_a(Mg_{(1-b)/3}Mn_{b/3}Sb_{2/3})_xTi_yZrO_3$ besteht, wobei M eines oder mehrere der Erdalkalimetalle Ca, Sr und Ba ist,

$$0 \leqslant a \leqslant 0,15,$$
$$0 \leqslant b \leqslant 0,20,$$
$$0,01 \leqslant x \leqslant 0,25,$$
$$0,40 \leqslant y \leqslant 0,55,$$
$$0,20 \leqslant z \leqslant 0,59 \text{ und}$$
$$(x + y + z) = 1.$$

2. Körper nach Anspruch 1, dadurch gekennzeichnet, dass $0,125 \leqslant x \ 0,15$, $0,44 \leqslant y \leqslant 0,46$ und $0,38 \leqslant z \leqslant 0,44$ ist, wobei M Sr ist und der Molanteil von Sr 0,05 ist.

3. Elektromechanischer Wandler mit einem piezoelektrischen Körper nach den Ansprüchen 1 oder 2.

4. Verfahren zum Herstellen eines piezoelektrischen Körpers nach Anspruch 1 oder 2, dadurch ge-

**0 019 337**

kennzeichnet, das der nach Sinterung der geeigneten Ausgangswerkstoffe erhaltene keramische Körper bei einer Temperatur zwischen 20 und 200°C an Luft oder in einem elektrisch nicht leitenden Oel in einem Feld von 1—3 MV/m zwischen 1 Sekunde und 5 Minuten polarisiert wird.

5. Verfahren zum Herstellen einer Anordnung, wobei ein piezoelektrischer Körper nach den Ansprüchen 1 oder 2 bei erhöhter Temperatur auf einer Vorrichtung befestigt wird, dadurch gekennzeichnet, dass die Polarisierung bei Raumtemperatur nach Beendigung des Befestigungsvorganges durchgeführt wird.

FIG.1

FIG.2

FIG.3